# EUROPEAN PATENT APPLICATION

(11) **EP 4 528 389 A1**
(43) Date of publication of application: **26.03.2025**
(21) Application number: 24200521.3
(22) Date of filing: 16.09.2024
(51) Int. Cl.: G04B 13/02, G04D 3/00, B81C 99/00

(54) **GEAR ASSEMBLY, TIMEPIECE, AND GEAR ASSEMBLY MANUFACTURING METHOD**

(30) Priority: 25.09.2023 JP 2023159312
(71) Applicant: Casio Computer Co., Ltd., Tokyo 151-8543 (JP)
(72) Inventor: Saito, Yuta, Hamura-shi, Tokyo, 205-8555 (JP); Iida, Masataka, Hamura-shi, Tokyo, 205-8555 (JP)
(74) Representative: Grünecker Patent- und Rechtsanwälte PartG mbB

(57) **Abstract**

Disclosed is a gear assembly (40), including: a shaft (40A); a spur gear (40B, 40C) that is made of a material having a crystal lattice plane and through which the shaft (40A) is inserted; and a fixing member (40D) that fixes the spur gear (40B, 40C) to the shaft (40A).

## Description

### BACKGROUND OF THE INVENTION

### Field of the Invention

The present disclosure relates to a gear assembly, a timepiece, and a method for manufacturing a gear assembly.

### Description of the Related Art

In the wheel train mechanism of wristwatches and the like, as disclosed in JP 2020-30092A, for example, a large number of gearwheels of different shapes and sizes are used. High-priced products, in particular, tend to be produced in small quantities and in many varieties and therefore, the manufacturing costs including the development costs tend to be high.

### SUMMARY OF THE INVENTION

A gear assembly (40) according to one aspect of the present disclosure comprises:
a shaft (40A);
a spur gear that is made of a material having a crystal lattice plane and through which the shaft (40A) is inserted; and
a fixing member (40D) that fixes the spur gear to the shaft (40A) .

A timepiece (100) according to another aspect of the present disclosure comprises:
a wheel train mechanism (33) that includes a gear assembly (40), the gear assembly (40) including:
   a shaft (40A);
   a spur gear that is made of a material having a crystal lattice plane and through which the shaft (40A) is inserted; and a fixing member (40D) that fixes the spur gear to the shaft (40A); and
   a case (101) that houses the wheel train mechanism (33).

A method for manufacturing a gear assembly (40) according to yet another aspect of the present disclosure is a method for manufacturing a gear assembly (40) that includes:
a gearwheel (40B) of a wheel train mechanism (33) of a timepiece (100); and
a pinion (40C) that is smaller in diameter than the gearwheel (40B), the method comprising:
   assembling the gear assembly (40) by inserting a shaft (40A) through the gearwheel (40B) and the pinion (40C) that are manufactured by photolithography from a single silicon wafer (W).

Further features of the present invention will become apparent from the following description of exemplary embodiments (with reference to the attached drawings).

### BRIEF DESCRIPTION OF THE DRAWINGS

In the drawings:
FIG. 1 is a front view of a major portion of a timepiece according to an embodiment;
FIG. 2 is a cross-sectional view of the wheel train mechanism of the hour hand drive mechanism in the timepiece according to the embodiment;
FIG. 3 is a cross-sectional view of an example of a gear assembly according to the embodiment;
FIG. 4 is a cross-sectional view of an example of a gear assembly according to the embodiment;
FIG. 5A, FIG. 5B, and FIG. 5C are plan views of a gearwheel according to the embodiment, in which

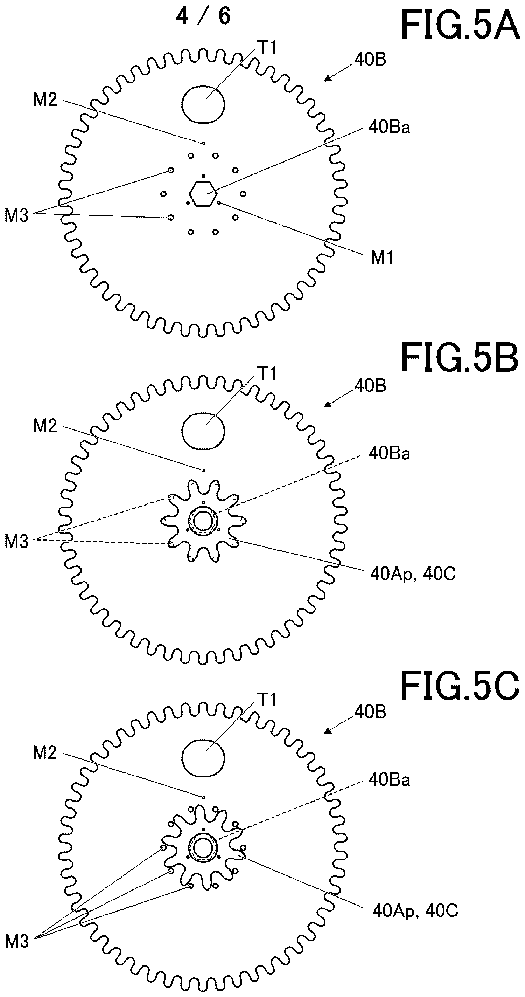

   FIG. 5A is a single-piece view,
   FIG. 5B illustrates a state where the circumferential direction of a shaft with respect to a pinion is proper, and
   FIG. 5C illustrates a state where the circumferential direction of the shaft with respect to the pinion is improper;

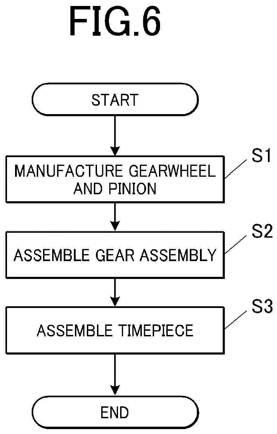

FIG. 6 is a flowchart illustrating the procedure of the method for manufacturing the timepiece according to the embodiment; and

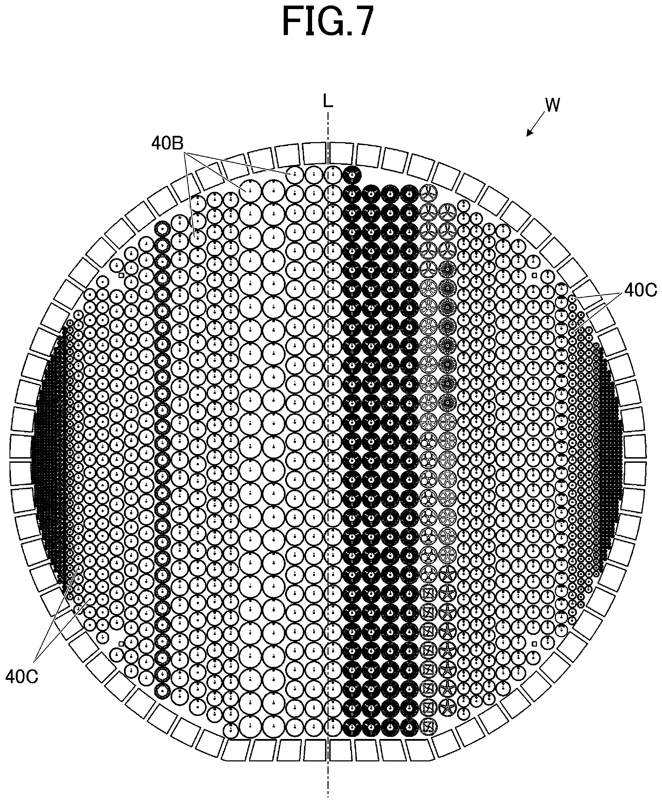

FIG. 7 is a diagram of an example of a silicon wafer on which the shapes of a plurality of gearwheels and pinions are transferred by photolithography.

### DESCRIPTION OF THE EMBODIMENTS

Hereinafter, one or more embodiments of the present invention will be described with reference to the drawings.

The embodiment described below is provided with various limitations technically preferable for carrying out the present invention. However, the scope of the present invention is not limited to the embodiment below or illustrated examples.

### [Overall Structure of Timepiece]

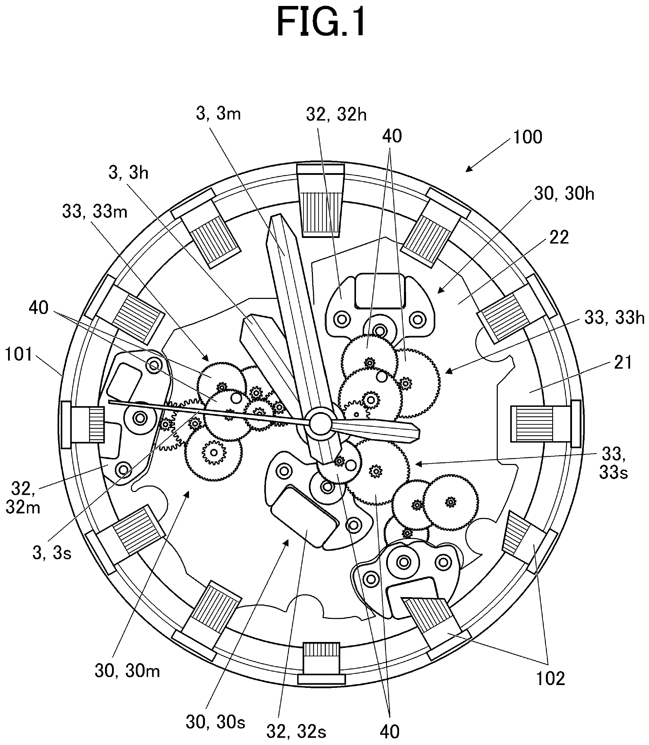

FIG. 1 is a front view of a major portion of a timepiece 100 according to the present embodiment. In FIG. 1, a dial, a portion of a main plate 21, and the like are omitted for easy understanding of the main structure.

As shown in FIG. 1, the timepiece 100 according to the present embodiment is an analog timepiece that displays time by pointing to an index 102 with a plurality of hands 3 (a second hand 3s, a minute hand 3m, and an hour hand 3h). The timepiece 100 includes a main body case 101 formed in a short cylindrical shape when viewed from the front.

Inside the main body case 101, the plurality of hands 3 and a plurality of drive mechanisms 30 that respectively rotate the plurality of hands 3 are housed.

The plurality of drive mechanisms 30 include a second hand drive mechanism 30s that rotates the second hand 3s, a minute hand drive mechanism 30m that rotates the minute hand 3m, and an hour hand drive mechanism 30h that rotates the hour hand 3h.

Each drive mechanism 30 includes a motor 32, which is a drive source, and a wheel train mechanism 33 that transmits the drive force of the motor 32 to the hand 3. Specifically, the second hand drive mechanism 30s includes the first motor 32s and the first wheel train mechanism 33s, the minute hand drive mechanism 30m includes the second motor 32m and the second wheel train mechanism 33m, and the hour hand drive mechanism 30h includes the third motor 32h and the third wheel train mechanism 33h.

Each wheel train mechanism 33 includes a plurality of gear assemblies 40.

For example, the first wheel train mechanism 33s of the second hand drive mechanism 30s includes gear assemblies 40 such as a fourth wheel and pinion (seconds wheel and pinion). The second wheel train mechanism 33m of the minute hand drive mechanism 30m includes gear assemblies 40 such as a second (center) wheel and pinion. The third wheel train mechanism 33h of the hour hand drive mechanism 30h includes gear assemblies 40 such as a minute wheel and an hour wheel.

The wheel train mechanism 33 may include a gear other than the gear assemblies 40. The gear in this case only needs to include at least a gearwheel and a shaft. The gearwheel and the shaft can be separate components as long as the gearwheel and the shaft are integrally combined.

### [Configuration of Gear Assembly]

As an example of the gear assemblies 40 according to the present embodiment, the configuration of the third wheel train mechanism 33h of the hour hand drive mechanism 30h will be described.

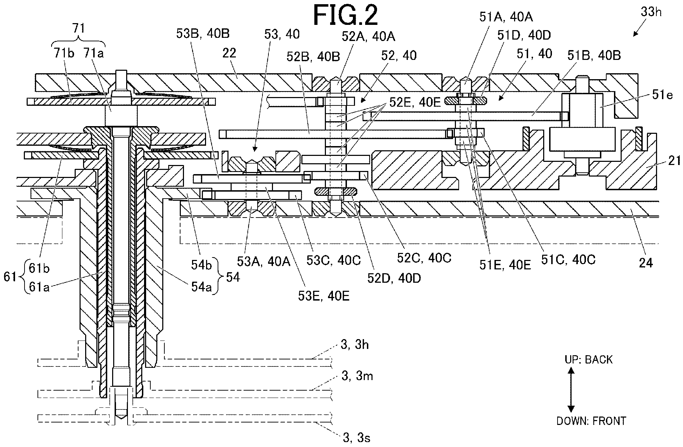

FIG. 2 is a cross-sectional view of the third wheel train mechanism 33h in the timepiece 100.

As shown in the drawing, the third wheel train mechanism 33h includes the first intermediate hour wheel 51, the second intermediate hour wheel 52, and a minute wheel 53 as the gear assemblies 40.

Each of the gear assemblies 40 includes a shaft 40A that serves as a rotation shaft, a gearwheel 40B that transmits torque, a pinion 40C that is smaller in diameter than the gearwheel 40B, a fixing member 40D that fixes other components to the shaft 40A, and a spacer 40E that adjusts the positions of the gearwheel 40B and the pinion 40C in the axial direction. The gear assembly according to the present invention only needs to include at least a shaft, a gearwheel, and a fixing member. In the gear assembly, each of the components other than the shaft may be multiple.

In the following, each component of the gear assembly 40 is identified by appending the following letters to the end of the reference numerals: "A" for the shaft, "B" for the gearwheel, "C" for the pinion, "D" for the fixing member, and "E" for the spacer. For example, the reference numeral for the shaft of the first intermediate hour wheel 51 is "51A."

Hereinafter, the front-back direction of the timepiece 100 is referred to as the up-down direction, with the front side (the lower side in FIG. 2) being called the "downward side" and the back side (the upper side in FIG. 2) being called the "upward side."

In the third wheel train mechanism 33h, the rotational force of the third motor 32h is transmitted in the order of the first intermediate hour wheel 51, the second intermediate hour wheel 52, the minute wheel 53, and the hour wheel 54 to rotate the hour hand 3h.

The first intermediate hour wheel 51 includes a shaft 51A, a gearwheel 51B, a pinion 51C, a fixing member 51D, and a plurality of spacers 51E. The shaft 51A is rotatably supported at both ends by a main plate 21 and a train wheel bridge 22. The train wheel bridge 22 is disposed on the upward side with respect to the main plate 21 and supports the upward end of the shaft 51A. The gearwheel 51B meshes with the rotor pinion 51e of the third motor 32h. The pinion 51C is connected to the second intermediate hour wheel 52.

The details of each component of the gear assembly 40 will be described later.

The second intermediate hour wheel 52 includes a shaft 52A, a gearwheel 52B, a pinion 52C, a fixing member 52D, and a plurality of spacers 52E. The shaft 52A is rotatably supported at both ends by the train wheel bridge 22 and the date dial guard 24. The date dial guard 24 is disposed on the downward side with respect to the main plate 21 and supports the downward end of the shaft 52A. The gearwheel 52B meshes with the pinion 51C of the first intermediate hour wheel 51. The pinion 52C is connected to the minute wheel 53.

The minute wheel 53 includes a shaft 53A, a gearwheel 53B, a pinion 53C, and a spacer 53E. The shaft 53A is rotatably supported at both ends by the main plate 21 and the date dial guard 24. The gearwheel 53B meshes with the pinion 52C of the second intermediate hour wheel 52. The pinion 53C is connected to the hour wheel 54.

The hour wheel 54 includes an hour wheel body 54a in a cylindrical shape in which the hour hand 3h is fixed to the downward end, and an hour gear 54b that is integrally formed with the hour wheel body 54a and meshes with the pinion 53C of the minute wheel 53. This allows the rotational force of the third motor 32h to be transmitted to the hour wheel 54 via the first intermediate hour wheel 51, the second intermediate hour wheel 52, and the minute wheel 53, thereby rotating the hour hand 3h at the downward end of the hour wheel body 54a.

The second wheel and pinion 61 and the fourth wheel and pinion 71 are inserted inside the hour wheel 54 and disposed coaxially.

The second wheel and pinion 61 includes a second wheel body 61a in a cylindrical shape and a second gear 61b. The second wheel body 61a is rotatably supported independently of the hour wheel 54 and the fourth wheel and pinion 71, and the minute hand 3m is fixed to the downward end thereof. The second gear 61b is fixed to the upward end of the second wheel body 61a and is connected to the second motor 32m. This allows the rotational force of the second motor 32m to be transmitted to the second wheel and pinion 61, thereby rotating the minute hand 3m at the downward end of the second wheel body 61a.

The fourth wheel and pinion 71 includes a fourth wheel body 71a in a shaft shape and a fourth gear 71b. The fourth wheel body 71a is inserted into the second wheel body 61a, rotatably supported independently of the hour wheel 54 and the second wheel and pinion 61, and the second hand 3s is fixed to the downward end thereof. The fourth gear 71b is fixed to the upward end of the fourth wheel body 71a and is connected to the first motor 32s. This allows the rotational force of the first motor 32s to be transmitted to the fourth wheel and pinion 71, thereby rotating the second hand 3s at the downward end of the fourth wheel body 71a.

In the following, each component of the gear assembly 40 will be described in detail.

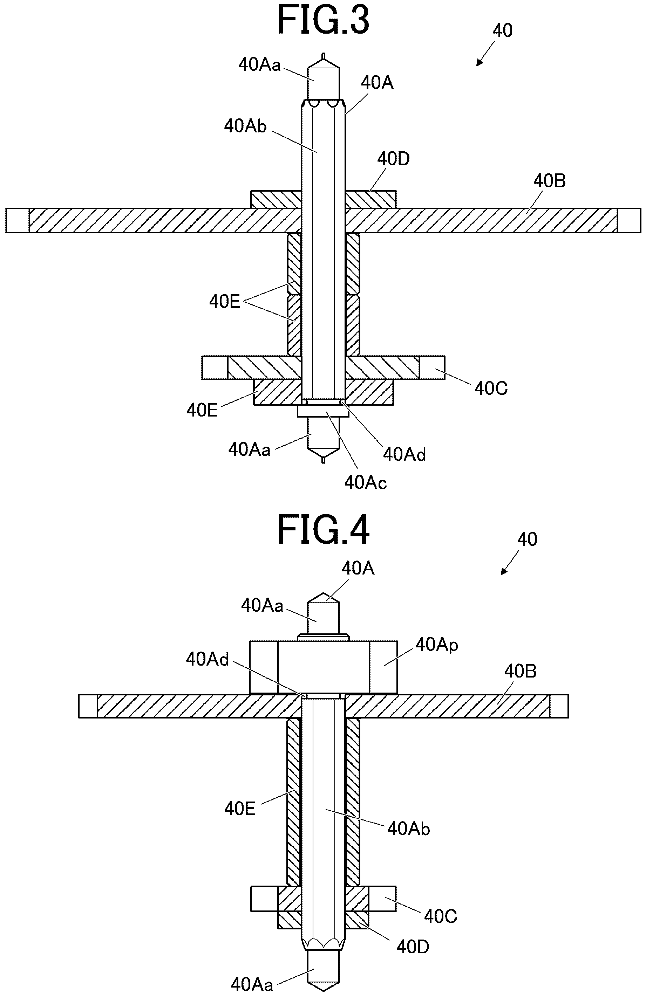

FIG. 3 and FIG. 4 are cross-sectional views of an example of the gear assembly 40.

### <Shaft>

As shown in FIG. 3, the shaft 40A is made of, for example, carbon tool steel (SK material), and includes supported portions 40Aa, an insertion portion 40Ab, and a flange 40Ac.

The supported portions 40Aa are rotatably supported, and are provided, for example, at both ends in the axial direction.

The insertion portion 40Ab is inserted through the gearwheel 40B, pinion 40C, fixing member 40D, and spacer 40E. The insertion portion 40Ab has a polygonal cross section (hexagonal in the examples of FIG. 3 and FIG. 4), for example, in order to prevent relative rotation with the inserted components. Each of the central portions of the gearwheel 40B, the pinion 40 C, the fixing member 40D, and the spacer 40E is provided with an insertion hole that has substantially the same cross-sectional shape as the insertion portion 40Ab. FIG. 5 illustrates an example of the insertion hole 40Ba of the gearwheel 40B.

The flange 40Ac is disposed, for example, at the end of the insertion portion 40Ab in the axial direction. The flange 40Ac abuts and positions the gearwheel 40B, the pinion 40C, or the spacer 40E, with the insertion portion 40Ab inserted, in the axial direction.

An escape groove 40Ad is formed in a shape recessed inwardly in a corner portion provided between the insertion portion 40Ab and the surface of the flange 40Ac that abuts the gearwheel 40B or the spacer 40E. In other words, the escape groove 40Ad is formed in a boundary portion between the insertion portion 40Ab and the flange 40Ac that has a larger diameter than the insertion portion 40Ab in the shaft 40A. That is, the recessed escape groove 40Ad is provided by forming the shaft 40A to have a portion with a smaller diameter than the insertion portion 40Ab. The escape groove 40Ad may have any shape that can escape from (avoid contact with) a corner portion of the insertion hole of the gearwheel 40B, the pinion 40C, or the spacer 40E.

As shown in FIG. 4, the shaft 40A may be integrally formed with a pinion (small gearwheel) 40Ap. In this case, instead of the flange 40Ac, the pinion 40Ap may be used to position the gearwheel 40B or the spacer 40E in the axial direction. In addition, it is preferable in this case to provide the escape groove 40Ad in a corner portion provided between the insertion portion 40Ab and the pinion 40Ap.

In the wheel train mechanism 33, a plurality of shafts 40A are supported by some common components (basal plates). For example, for the third wheel train mechanism 33h, as shown in FIG. 2, each of the shafts 40A is supported by any two of the main plate 21, the train wheel bridge 22, and the date dial guard 24. Therefore, when only the length in the up-down direction (axial direction) is considered as a reference, the shaft 40 A can be roughly classified into: a shaft extending from the train wheel bridge 22 to the main plate 21; a shaft extending from the train wheel bridge 22 to the date dial guard 24; and a shaft extending from the main plate 21 to the date dial guard 24. That is, a common shaft 40A can be used for a plurality of gear assemblies 40 that have a common basal plate to be supported. If the basal plate to be supported (or axial position thereof) is common, the shaft 40A can also be used in common with the other wheel train mechanisms 33.

### <Gearwheel and Pinion>

FIG. 5A, FIG. 5B, and FIG. 5C are plan views of the gearwheel 40B. FIG. 5A is a single-piece view. FIG. 5B illustrates a state where the circumferential direction of the shaft 40 with respect to the pinion 40Ap is proper. FIG. 5C illustrates a state where the circumferential direction of the shaft 40A with respect to the pinion 40Ap is improper.

As shown in FIG. 5A and FIG. 5B, both the gearwheel 40B and the pinion 40C are spur gears made of, for example, silicon, and the pinion 40C is smaller in diameter than the gearwheel 40B. The gearwheel 40B and pinion 40C of the present embodiment are manufactured from a silicon wafer by photolithography as described later.

An insertion hole 40Ba through which the shaft 40A is inserted is formed in the center of each of the gearwheels 40B The insertion hole 40Ba is formed in a polygonal shape corresponding to the shape of the insertion portion 40Ab of the shaft 40A.

A hand position detection hole T1 penetrating in the thickness direction is formed at a predetermined position on the outer peripheral side of each gearwheel 40B. The hand position detection holes T1 formed in the respective gearwheels 40B overlapping each other in the up-down direction overlap at a predetermined timing (period) when the hands are moving. The light from a light emitter passes through the hand position detection holes T1 overlapped by way of the plurality of gearwheels 40B and is detected by a light detector. This allows the positions of the hands 3 to be detected.

The first mark M1 for determining the gearwheel type is formed around the insertion hole 40Ba of each of the gearwheels 40B. The first mark M1 varies in hole shape, quantity, position, and the like, depending on the type of the gearwheels 40B, for example.

The second mark M2 for determining the direction is formed on each of the gearwheels 40B. However, in the gearwheel 40B where the hand position detection hole T1 is formed, the second mark M2 may not be provided in a case where the direction is determined by the hand position detection hole T1.

The positions, quantities, shapes, and the like of the first mark M1 and the second mark M2 are not particularly limited. However, when the first mark M1 and the second mark M2 are disposed in the vicinity of the hand position detection hole T1, there is a risk that the light passing through the first mark M1 and the second mark M2 may cause erroneous detection. Therefore, it is preferable that the first mark M1 and the second mark M2 are formed in the vicinity of the insertion hole 40Ba.

Further, the third marks M3 for aligning the circumferential direction with the pinion 40C (or pinion 40Ap) are formed on each of the gearwheels 40B.

The third marks M3 are formed on the gearwheel 40B at the positions corresponding to the teeth (crests) of the pinion 40C when the pinion 40C is assembled in the proper circumferential direction. Therefore, as shown in FIG. 5B, when the gearwheel 40B and pinion 40C are assembled in the proper circumferential direction, the third marks M3 are covered by the teeth of the pinion 40C. On the other hand, as shown in FIG. 5C, for example, when the circumferential direction of the pinion 40C deviates from the proper position by one pitch of the insertion hole 40Ba, the third marks M3 are exposed from the valleys of the pinion 40C. This allows the assembler (or inspector) to easily determine whether the gearwheel 40B and pinion 40C are properly assembled based on whether the third marks M3 are exposed from the pinion 40C.

The hand position detection hole T1 may also serve as the third marks M3.

It is preferable that the first mark M1, the second mark M2, and the third marks M3 are formed to be as small as possible while not excessively reducing the strength of the gearwheel 40B. For example, when manufacturing the gearwheel 40B with a photoresist mask, it is preferable to set the size to about ϕ0.05 to ϕ0.1 mm, which is the limit of processing accuracy. However, of course, it is necessary to have enough size to be visually confirmed by a worker at the time of assembly.

The gearwheel 40B and the pinion 40C are fixed to the shaft 40A integrally (or individually) with other components by the fixing member 40D. Alternatively, the gearwheel 40B and the pinion 40C may be fixed to the shaft 40A with an adhesive. In this case, the escape groove 40Ad of the shaft 40A can be used as a reservoir groove for the adhesive so that the excess adhesive can be prevented from protruding. The gearwheel 40B and the pinion 40C may be made of a material having ductility (malleability) such as nickel or brass and may be fixed to the shaft 40A by press-fitting.

The pinion 40C may be divided into pieces in the axial direction. That is, a plurality of pinions 40 C may be overlapped in the axial direction to increase the thickness

### <Fixing Member>

As shown in FIG. 3 and FIG. 4, the fixing member 40D is press-fitted into the shaft 40A, and fixes the gearwheel 40B, pinion 40C, and spacer 40E to the shaft 40A. The fixing member 40D is formed, for example, in a short annular shape with a thickness of about 0.1 mm.

The material of the fixing member 40D is, for example, nickel or the like, and is not particularly limited as long as the fixing member 40D can be press-fitted into the shaft 40A.

When the gearwheel 40B and pinion 40C are fixed to the shaft 40A by press-fitting, the fixing member 40D may be omitted.

### <Spacer>

The spacer 40E is formed in a cylindrical shape, through which the shaft 40A is inserted, and adjusts the positions of the gearwheel 40B and the pinion 40C in the axial direction. The length of the spacer 40E in the axial direction is not particularly limited. A plurality of short spacers 40E may be combined and a single shaft 40A is inserted therethrough.

When the spacer 40E is disposed between the gearwheel 40B and the pinion 40C, it is preferable that the size of the spacer 40E is smaller in diameter than the root circles of the gearwheel 40B and the pinion 40C. This makes it possible to freely adjust the height of the pinion 40C to an optimum height in accordance with needs while securing a gap in the height direction between the interlocking gearwheels 40B.

The material of the spacer 40E is not particularly limited. For example, the material may be silicon, nickel, brass, or the like. In the case of the spacer 40E made of silicon by photolithography, for example, even when a plurality of spacers is stacked, the high smoothness of the end face can suppress tilting.

### [Manufacturing Method]

FIG. 6 is a flowchart illustrating the procedure of the method for manufacturing the timepiece 100 that includes the gear assemblies 40. FIG. 7 is a diagram of an example of a silicon wafer W on which the shapes of a plurality of gearwheels 40B and pinions 40C are transferred by photolithography.

As shown in FIG. 6, in the manufacturing method of the timepiece 100, first, the gearwheels 40B and pinions 40C are manufactured by lithography (step S1).

As shown in FIG. 7, in this step, a plurality of types of gearwheels 40B and pinions 40C used for a single timepiece 100 are manufactured from a single silicon wafer W. The thickness of the silicon wafer W is about 0.1 to 0.15 mm at the thickest.

The gearwheels 40B and pinions 40C are disposed (aligned) so that the larger the diameter, the closer the gearwheels 40B and pinions 40C are to the centerline L that substantially bisects the silicon wafer W. The width of each row of the gearwheels 40B and pinions 40C, which is the length in the direction perpendicular to the centerline L, is set to be constant along the centerline L as much as possible. This allows the gearwheels 40B and pinions 40C to be disposed such that wasteful extra space is unlikely to be generated on the substantially circular silicon wafer W. However, the arrangement of the gearwheels 40B and pinions 40C on the silicon wafer W may be properly adjusted so that the extra space on the silicon wafer W can be minimized.

The spacer 40E may be manufactured from the same single silicon wafer W together with the gearwheel 40B and the pinion 40C.

Next, as shown in FIG. 6, each of the gear assemblies 40 is assembled (step S2).

In this step, the gear assembly 40 shown in FIG. 3 is assembled by inserting the shaft 40A through the gearwheel 40B, the pinion 40C, and the spacer 40E, and then, with the gearwheel 40B, pinion 40C, and spacer 40E interposed between the fixing member 40D and the flange 40Ac, press-fitting the fixing member 40D.

Alternatively, the gear assembly 40 shown in FIG. 4 is assembled by inserting the shaft 40A through the gearwheel 40B, the pinion 40C, and the spacer 40E, and then, with the gearwheel 40B, pinion 40C, and spacer 40E interposed between the fixing member 40D and the pinion 40Ap, press-fitting the fixing member 40D.

In this step, the assembler checks the first mark M1 of the gearwheel 40B, determines the type thereof, and combines the gearwheel 40B with the corresponding shaft 40A, pinion 40C, and the like.

The assembler also checks the third marks M3 of the gearwheel 40B and assembles the pinion 40C to the gearwheel 40B so that the third marks M3 are covered by the teeth of the pinion 40C (or pinion 40Ap). This allows the gearwheel 40B and the pinion 40C (or pinion 40Ap) to be assembled in the proper circumferential direction.

Next, the entire timepiece 100 is assembled (step S3).

In this step, the module that includes the wheel train mechanisms 33 with a plurality of gear assemblies 40 assembled in the step S2, the hands 3, and the like is incorporated into the main body case 101. Furthermore, for example, in the case of an electronic timepiece, a clocking circuit, battery block, and the like are incorporated, and in the case of a mechanical timepiece, an escape wheel, balance spring, and the like are incorporated, as necessary.

The timepiece 100 is assembled in this way.

### [Technical Effects of the Embodiments]

As described above, according to the present embodiment, each of the gear assemblies 40 includes the shaft 40A, the gearwheel 40B made of silicon, and the fixing member 40D that fixes the gearwheel 40B to the shaft 40A. When the gearwheel 40B is made of metal, the fixing member 40D is not used because the structure becomes complicated. In this case, by forming the inner diameter of the metal gearwheel 40B slightly smaller than the outer shape of the shaft 40A, the gearwheel 40B is fixed to the shaft 40A by press-fitting. On the other hand, when the gearwheel 40B is made of silicon, since the gearwheel 40B is made of a hard material, the gearwheel 40B cannot be fixed to the shaft by press-fitting. However, by using the fixing member 40D, the gearwheel 40B can be fixed to the shaft 40A even if the gearwheel 40B is made of silicon. This allows the silicon gearwheel 40B to be used.

In addition, the above configuration allows a common shaft 40A to be used by a plurality of gear assemblies 40 of different types by, for example, replacing only the gearwheel 40B. Therefore, this makes it possible to suppress the development times and development costs even for products of a small amount and a large variety. Consequently, the manufacturing costs including the development costs can be reduced.

Further, using the gearwheel 40B made of silicon reduces friction because the gearwheel is harder and has higher smoothness of the surface than a gearwheel made of metal or resin, thereby suppressing power consumption (energy consumption) when the hands are moving. In particular, since the power consumption of driving the second hand 3s is larger than that of driving the other hands 3, the application to the second hand drive mechanism 30s is highly effective. Reducing the friction of the gearwheel 40B also makes it possible to reduce backlash, thereby improving the positional accuracy of the hands 3.

According to the present embodiment, each of the gear assemblies 40 includes the pinion 40C made of silicon having a smaller diameter than the gearwheel 40B, and the fixing member 40D fixes the pinion 40C to the shaft 40A. That is, the pinion 40C can be separated from the shaft 40A.

This makes it possible to reduce the quantity of shafts with pinions, which are particularly expensive to develop. Consequently, the manufacturing costs including the development costs can be further reduced.

According to the present embodiment, each of the gearwheels 40B includes the third marks M3 for aligning the circumferential direction with the pinion 40C. The third marks M3 are covered by the teeth of the pinion 40C when the pinion 40C is assembled in the proper circumferential direction. The third marks M3 are formed at the positions where the third marks M3 are exposed from between the teeth of the pinion 40C when the pinion 40C is not assembled in the proper circumferential direction.

This allows the assembler to easily determine whether the gearwheel 40B and pinion 40C are assembled in the proper circumferential direction (relative rotational angle) by checking whether the third marks M3 are exposed from the pinion 40C.

To detect the position of each of the hands 3, the hand position detection holes T1 of a plurality of gearwheels 40B are rotated to overlap each other. The position of the hand 3 is then detected based on the amount of light passing through the overlapping hand position detection holes T1. Here, when the gearwheel 40B and pinion 40C are assembled in the proper circumferential direction, the hand position detection holes T1 are also assembled in the proper circumferential direction. Consequently, when the position of the hand 3 is detected, the plurality of hand position detection holes T1 overlap as expected, maximizing the amount of light passing through the hand position detection holes T1. This makes it possible to detect the position of the hand 3 with high precision. Conversely, if the gearwheel 40B and pinion 40C are not assembled in the proper circumferential direction, the hand position detection holes T1 are also not assembled in the proper circumferential direction. Consequently, the position of the hand 3 cannot be accurately detected.

According to the present embodiment, each of the gear assemblies 40 includes the spacer 40E through which the shaft 40A is inserted.

This allows the heights (positions in the axial direction) of the gearwheel 40B and the pinion 40C to be individually adjusted by the spacer 40E while using a common shaft 40A for a plurality of gear assemblies 40.

According to the present embodiment, the shaft 40A has the escape groove 40Ad in the corner portion provided between the insertion portion 40Ab and the surface of the flange 40Ac that contacts the gearwheel 40B.

This prevents the corner portion of the insertion hole of the gearwheel 40B from coming into contact with the corner portion provided between the insertion portion 40Ab and flange 40Ac of the shaft 40A, thereby suppressing chipping of the corner portions.

That is, since the silicon gearwheel 40B is very hard and manufactured by photolithography, the corner portion is likely to be chipped when stress is concentratively applied thereto, and also difficult to chamfer. Thus, it is not desirable that the corner portion provided between the insertion portion 40Ab and flange 40Ac has a corner R that can interfere with (contact) the gearwheel 40B at the time of assembly. However, when the flange 40Ac is formed by a normal cutting process, it is inevitable to form the corner R in the corner portion provided between the insertion portion 40Ab and the flange 40Ac. Therefore, by performing additional cutting in the radial direction (toward the center) on the corner portion provided between the insertion portion 40Ab and flange 40Ac, the corner R is removed, and the escape groove 40Ad is provided in the shaft 40A so that the shaft has a portion with a smaller diameter than the insertion portion 40Ab. This makes it possible to avoid interference between the shaft 40A and the gearwheel 40B at the time of assembling. This allows the gearwheel 40B to be suitably assembled to the shaft 40A without making it difficult to position the gearwheel 40B by reducing the size of the gearwheel 40B in order to avoid the corner R. That is, the gearwheel 40B can be positioned accurately in both the axial and radial directions.

It is preferable that the processing direction of the escape groove 40Ad is in the radial direction (toward the center). When the escape groove 40Ad is to be processed in the axial direction, a hexagonal undercut corresponding to the shape of the insertion portion 40Ab is required. On the other hand, setting the processing direction of the escape groove 40Ad to the radial direction (toward the center) allows the escape groove 40Ad to be formed relatively easily by cutting.

Also, when the gearwheel 40B is bonded to the shaft 40A with an adhesive, the escape groove 40Ad can be used as a reservoir groove for the adhesive. This suppresses the excess adhesive from protruding from the gap between the shaft 40A and the gearwheel 40B and/or from the escape groove 40A. Consequently, an occurrence of malfunction due to the protruding adhesive can be suppressed.

According to the present embodiment, a plurality of types of gearwheels 40B and pinions 40C are manufactured from a single silicon wafer W by photolithography.

This allows the plurality of types of gearwheels 40B and pinions 40C to be suitably manufactured while using a common shaft 40A for a plurality of gear assemblies 40. This makes it possible to suppress the development times and development costs even for products of a small amount and a large variety. Consequently, the manufacturing costs including the development costs can be reduced.

In addition, since a plurality of types of gearwheels 40B and pinions 40C are manufactured from a single silicon wafer W by photolithography, the plurality of types of gearwheels 40B and pinions 40C can be formed with the same thickness (length in the up-down direction). Further, the main surface of the silicon wafer W, which is the surface normal to the thickness direction of the silicon wafer W, has high smoothness. Accordingly, even when a plurality of at least one of the gearwheel 40B, the pinion 40C, the fixing member 40D, or the spacer 40E are stacked, the gear assembly 40 can be formed such that the thickness after the stacking becomes as intended with high precision.

Therefore, even when the third wheel train mechanism 33h is manufactured by combining the first intermediate hour wheel 51, the second intermediate hour wheel 52, and the minute wheel 53 as in the present embodiment, the heights (positions in the up-down direction) of those that mesh with each other, among the first intermediate hour wheel 51, the second intermediate hour wheel 52, and the minute wheel 53, can be set with high precision.

Furthermore, since the main surfaces of the gearwheel 40B, pinion 40C, fixing member 40D, and spacer 40E (the surfaces normal to the up-down direction) have high smoothness, the loss of power energy due to friction between the main surfaces can also be suppressed to a very low level.

According to the present embodiment, a plurality of gearwheels 40B and pinions 40C are disposed on a single silicon wafer W so that the larger the diameter, the closer the gearwheels 40B and pinions 40C are to the centerline L of the silicon wafer W. In this case, the gearwheels 40B and pinions 40C of the same diameter are disposed in a direction parallel to the centerline L of the silicon wafer W.

This allows the plurality of gearwheels 40B and pinions 40C to be suitably disposed on the silicon wafer W, reducing wasteful extra space on the silicon wafer W. Therefore, the manufacturing costs can be further reduced.

According to the present embodiment, the spacer 40E is manufactured from the same silicon wafer W as the gearwheel 40B and the pinion 40C.

This allows for further reduction of the manufacturing costs.

### [Others]

The embodiments to which the present invention can be applied are not limited to the above-described embodiments, and various modifications can be made without departing from the scope of the present invention.

For example, in the above embodiment, the gearwheels and the pinions (or the spacers) are made of silicon having a crystal lattice plane and are manufactured by photolithography. However, the material of the gearwheels and the pinions (or the spacers) is not limited to silicon, and the manufacturing method is not limited to photolithography.

For example, as a material having a crystal lattice plane, a wafer made of diamond may be used. Furthermore, the gearwheels and the pinions (or the spacers) may be made of nickel, brass, or the like by electroforming. The thickness of the electroformed wafer is the same as that of the silicon wafer. In this case, since the gearwheel and the pinion can be press-fitted into the shaft, the fixing member may be omitted. However, since nickel is a magnetic material, nickel is not applied to the gearwheel and the pinion that mesh with a motor.

The gear assembly according to the present invention is not limited to a gear assembly used in a wheel train mechanism of a timepiece and can be widely applied to a gearwheel through which a shaft is inserted. In particular, the present invention can be suitably applied to a small gear mechanism in which it is difficult to adopt a complicated bearing structure.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

This application claims the benefit of Japanese Patent Application No. 2023-159312, filed September 25, 2023 which is hereby incorporated by reference wherein in its entirety.

## Claims

1. A gear assembly (40), comprising:
a shaft (40A);
a spur gear (40B, 40C) that is made of a material having a crystal lattice plane and through which the shaft (40A) is inserted; and
a fixing member (40D) that fixes the spur gear (40B, 40C) to the shaft (40A).

2. The gear assembly (40) according to claim 1, wherein
the spur gear (40B, 40C) includes a gearwheel (40B) through which the shaft (40A) is inserted and/or a pinion (40C) that is smaller in diameter than the gearwheel (40B) and through which the shaft (40A) is inserted, and
the fixing member (40D) fixes the gearwheel (40B) and/or the pinion (40C) to the shaft (40A).

3. The gear assembly (40) according to claim 2, wherein
the gearwheel (40B) includes a mark (M3) for aligning a circumferential direction with the pinion (40C), and
the mark (M3) is formed at a position where:
the mark (M3) is covered by a tooth of the pinion (40C) when the pinion (40C) is assembled in a proper circumferential direction; and
the mark (M3) is exposed through between teeth of the pinion (40C) when the pinion (40C) is not assembled in the proper circumferential direction.

4. The gear assembly (40) according to claim 3, wherein the gearwheel (40B) has a hole (T1) for detecting a position of a hand.

5. The gear assembly (40) according to claim 4, wherein the hole (T1) for detecting the position of the hand also serves as the mark (M3).

6. The gear assembly (40) according to any one of claim 1 to claim 5, wherein the spur gear (40B, 40C) is made of silicon.

7. The gear assembly (40) according to claim 6, wherein
the spur gear (40B, 40C) is a gearwheel (40B) through which the shaft (40A) is inserted,
the shaft (40A) includes an insertion portion (40Ab) and a flange (40Ac) that is larger in diameter than the insertion portion (40Ab), and
the shaft (40A) has an escape groove (40Ad) in a corner portion provided between the insertion portion (40Ab) and a surface of the flange (40Ac) that contacts the gearwheel (40B).

8. The gear assembly (40) according to any one of claim 1 to claim 7, further comprising a spacer (40E) that is made of a material having a crystal lattice plane and through which the shaft (40A) is inserted, wherein
the fixing member (40D) fixes the spacer (40E) to the shaft (40A).

9. The gear assembly (40) according to claim 8, wherein
the spacer (40E) is made of silicon,
the shaft (40A) includes an insertion portion (40Ab) and a flange (40Ac) that is larger in diameter than the insertion portion (40Ab), and
the shaft (40A) has an escape groove (40Ad) in a corner portion provided between the insertion portion (40Ab) and a surface of the flange (40Ac) that contacts the spacer (40E).

10. The gear assembly according to claim 1, wherein
the spur gear (40B, 40C) is a gearwheel (40B) through which the shaft (40A) is inserted,
the shaft (40A) is integrally formed with a pinion (40Ap) that is smaller in diameter than the gearwheel (40B), and
the shaft (40A) has an escape groove (40Ad) in a corner portion provided between the shaft (40A) and a surface of the pinion (40Ap) that contacts the gearwheel (40B).

11. A timepiece (100), comprising:
a wheel train mechanism (33) that includes the gear assembly (40) according to any one of claim 1 to claim 10; and
a case (101) that houses the wheel train mechanism (33).

12. A method for manufacturing a gear assembly (40) that includes:
a gearwheel (40B) of a wheel train mechanism (33) of a timepiece (100); and
a pinion (40C) that is smaller in diameter than the gearwheel (40B), the method comprising:
assembling the gear assembly (40) by inserting a shaft (40A) through the gearwheel (40B) and the pinion (40C) that are manufactured by photolithography from a single silicon wafer (W).

13. The method for manufacturing the gear assembly (40) according to claim 12, wherein in the assembling, the gearwheel (40B) and the pinion (40C) are manufactured by photolithography from the single silicon wafer (W) in which the gearwheel (40B) and the pinion (40C) with larger diameters are disposed closer to a centerline of the silicon wafer (W).

14. The method for manufacturing the gear assembly (40) according to claim 12 or claim 13, wherein
the gear assembly (40) further includes a spacer (40E) that adjusts a position of the gearwheel (40B) and a position of the pinion (40C), and
in the assembling, the shaft (40A) is inserted through the gearwheel (40B), the pinion (40C), and the spacer (40E) that are manufactured by photolithography from the single silicon wafer (W).

15. The method for manufacturing the gear assembly (40) according to any one of claim 12 to claim 14, wherein in the assembling, the shaft (40A) is inserted through the gearwheel (40B) and the pinion (40C) such that
a mark (M3) formed on the gearwheel (40B) for aligning a circumferential direction with the pinion (40C) is covered by a tooth of the pinion (40C), wherein
the mark (M3) is formed at a position where:
the mark (M3) is covered by the tooth of the pinion (40C) when the pinion (40C) is assembled in a proper circumferential direction; and
the mark (M3) is exposed through between teeth of the pinion (40C) when the pinion (40C) is not assembled in the proper circumferential direction.
